(19)

Europäisches Patentamt
European Patent Office
Office européen des brevets

(11) **EP 4 257 990 A1**

(12) **EUROPEAN PATENT APPLICATION**
published in accordance with Art. 153(4) EPC

(43) Date of publication:
**11.10.2023 Bulletin 2023/41**

(21) Application number: **21902516.0**

(22) Date of filing: **03.12.2021**

(51) International Patent Classification (IPC):
**G01R 23/02** (2006.01)

(52) Cooperative Patent Classification (CPC):
**G01R 23/02**

(86) International application number:
**PCT/CN2021/135511**

(87) International publication number:
**WO 2022/121809 (16.06.2022 Gazette 2022/24)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.12.2020 CN 202011414104**

(71) Applicant: **Origin Quantum Computing
Technology
(Hefei) Co., Ltd
Hefei, Anhui 230088 (CN)**

(72) Inventors:
• **SHI, Hanqing
Hefei, Anhui 230088 (CN)**
• **KONG, Weicheng
Hefei, Anhui 230088 (CN)**

(74) Representative: **Rau, Schneck & Hübner
Patentanwälte Rechtsanwälte PartGmbB
Königstraße 2
90402 Nürnberg (DE)**

(54) **METHOD AND DEVICE FOR CALIBRATING FREQUENCY OF SUPERCONDUCTING QUBIT,
AND READABLE STORAGE MEDIUM**

(57)     Disclosed are a method and a device for calibrating a frequency of a superconducting qubit, and a readable storage medium, applying the microwave signal to the superconducting qubit and obtaining the initial oscillation frequency; then determining, based on the difference between the initial oscillation frequency and the first frequency, whether the frequency of the superconducting qubit has drifted or not; adjusting the magnitude of the first voltage applied on the superconducting qubit in the case that the frequency of the superconducting qubit has drifted so that the oscillation frequency is constantly approximating the first frequency, until the difference between the initial oscillation frequency and the first frequency satisfies a convergence condition. By adjusting the magnitude of the first voltage so that the oscillation frequency is constantly approximating the first frequency, it is possible to adjust the frequency of the superconducting qubit back to a predetermined value, that is, to return the superconducting qubit we selected to the operating point, thus enabling automatic calibration of the frequency of the superconducting qubit that has drifted.

S1: Applying a microwave signal and a first voltage to a superconducting qubit, and obtaining an oscillation frequency of the superconducting qubit corresponding to a value of the first voltage, wherein the microwave signal is of a first frequency — S1

S2: Determining, based on a difference between the oscillation frequency and the first frequency, whether the frequency of the superconducting qubit has drifted or not — S2

S3: Adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition — S3

**FIG. 1**

## Description

The present disclosure claims priority to Chinese patent application No.202011414104.9 entitled "METHOD AND DEVICE FOR CALIBRATING FREQUENCY OF SUPERCONDUCTING QUBIT, AND READABLE STORAGE MEDIUM", filed on December 7, 2020, which is hereby incorporated by reference in its entirety.

## TECHNICAL FIELD

The present disclosure relates to the field of quantum measurement and control, and in particular to a method and a device for calibrating a frequency of a superconducting qubit, and a readable storage medium.

## BACKGROUND

Quantum computation and quantum information is an interdisciplinary subject based on the principles of quantum mechanics to achieve computing tasks and information processing tasks, are closely related to quantum physics, computer science, informatics and other disciplines, and has been developing rapidly in the past two decades. Quantum algorithms based on quantum computers for scenarios such as factorization and unstructured search have shown performance far beyond existing algorithms based on classical computers, and are expected to surpass existing computing capabilities. Since quantum computing has the potential to far exceed the performance of classical computers in solving specific problems, in order to realize quantum computers, it is necessary to obtain a quantum chip containing a sufficient number and sufficient quality of qubits, and it is necessary to be able to perform quantum logic gate operations and readouts on qubits with extremely high fidelity.

In an approach known as circuit quantum electrodynamics, quantum computing employs nonlinear superconducting devices called superconducting qubits for manipulating and storing quantum information at microwave frequencies, and resonators (e.g., as two-dimensional (2D) planar waveguides or as three-dimensional (3D) microwave cavities) for readout and for facilitating interactions between qubits. As an example, each superconducting qubit may include one or more Josephson junctions, which are shunted with capacitors in parallel. The qubits are capacitively coupled to this 2D or 3D microwave cavity, and the electromagnetic energy associated with the superconducting qubits are stored in the Josephson junctions and in the capacitive and inductive elements that form the superconducting qubits. To enable a superconducting qubits to operate, the superconducting qubits are coupled to a flux modulation line, and typically the flux modulation line provides a flux modulation signal that modulates the electromagnetic energy associated with the superconducting qubits, and then controls the working performance of the superconducting qubits.

However, frequency of the superconducting qubit parameters of the superconducting qubit will fluctuate with the environment. If this fluctuation is ignored, it will lead to a decrease in the fidelity of the quantum logic gate operation, and will also affect the efficiency of readout. Therefore, it is necessary to regularly calibrate the parameters of the quantum chip, especially the frequency parameters of the superconducting qubits, so as to ensure long-term and stable performance of the best performance, that is, to ensure the best execution effect of the quantum algorithm. Because superconducting qubits will randomly and probabilistically drift in frequency, and the existing technical means of calibrating the frequency of the superconducting qubit rely on a lot of manpower and are time-consuming, they are not practical in large-scale quantum chip applications.

Therefore, how to realize the function of automatically calibrating the frequency of the superconducting qubit has become an urgent technical problem in this field.

It should be noted that the information disclosed in the background part of the present application is only intended to deepen the understanding of the general background of the present application, and should not be regarded as acknowledging or in any form implying that the information constitutes the prior art known to those skilled in the art.

## SUMMARY

An objective of the present disclosure is to provide a method and a device for calibrating a frequency of a superconducting qubit, and a readable storage medium, which are used for solving the problem that the frequency of the superconducting qubit cannot be automatically calibrated in the prior art.

For solving the above technical problem, a method for calibrating a frequency of a superconducting qubit is provided by the present disclosure, which method including following steps: applying a microwave signal and a first voltage to a superconducting qubit and obtaining an oscillation frequency of the superconducting qubit corresponding to a value of the first voltage, wherein the microwave signal is of a first frequency; determining, based on a difference between the oscillation frequency and the first frequency, whether the frequency of the superconducting qubit has drifted or not; adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition.

Optionally, during each adjusting of the value of the first voltage, a current estimated value and a current oscillation frequency corresponding to the current estimated value are output, wherein said "adjusting the value of the first voltage", includes: obtaining a number n of current completions of adjusting the value of the first voltage; obtaining an initial value $V_0$ of the first voltage if the number n is less than a first preset value; adjusting the value of the first voltage to a first estimated value $= V_0 + \Delta V$ according to the initial value $V_0$ and a preset adjustment amplitude $\Delta V$; and updating the initial value $V_0$ of the first voltage as the first estimated value when the number n is less than the preset number minus 1.

Optionally, said "adjusting the value of the first voltage", further includes: obtaining the initial value $V_0$ and the current estimated value $V_1$ as well as an initial oscillation frequency $f_0$ corresponding to the initial value $V_0$, and the current oscillation frequency $f_1$ if the number n is greater than or equal to the first preset value; based on the initial value $V_0$ and the current estimated value $V_1$ as well as the initial oscillation frequency $f_0$ and the current oscillation frequency $f_1$, adjusting the value of the first voltage to a second estimated value $V_2$:

$$V_2 = V_1 + \frac{V_1 - V_0}{f_1 - f_0} \times (f - f_1)$$

.

Optionally, said "adjusting the value of the first voltage", further includes: obtaining an oscillation frequency $f_2$ corresponding to the second estimated value $V_2$; determining if $|f_{2\text{-}f}|$ is less than $|f_1\text{-}f|$ or not; if yes, updating the initial value $V_0$ to $V_2$, and updating the initial oscillation frequency $f_0$ to $f_2$.

Optionally, during each adjusting of the magnitude of the first voltage, if the magnitude of the current oscillation frequency varies in a direction away from the magnitude of the first frequency after the first voltage is adjusted in a first direction, adjusting the first voltage in a second direction during the next adjusting of the magnitude of the first voltage; if the magnitude of the current oscillation frequency varies in a direction approximating the magnitude of the first frequency after the first voltage is adjusted in the first direction, adjusting the first voltage in the first direction during the next adjusting of the magnitude of the first voltage; wherein the first direction is opposite to the second direction.

Optionally, adjusting the first voltage according to voltage values of the same magnitude or different magnitudes during each adjusting of the value of the first voltage.

Optionally, further including following steps: setting an adjustment number threshold; determining, before each adjusting of the first voltage, whether a current adjustment number exceeds the adjustment number threshold or not; if yes, selecting an oscillation frequency most approximate to the first frequency and a corresponding first voltage as a calibration result, and completing calibration; if not, adjusting the first voltage.

Optionally, said "determining, based on a difference between the initial oscillation frequency and the first frequency, whether the frequency of the superconducting qubit has drifted or not", includes: determining that the frequency of the superconducting qubit has drifted when an absolute value of the difference between the initial oscillation frequency and the first frequency is greater than a first threshold; determining that the frequency of the superconducting qubit has not drifted when the absolute value of the difference between the initial oscillation frequency and the first frequency is less than or equal to the first threshold; wherein the first threshold is a pre-configured value.

Optionally, the convergence condition includes: an absolute value of the difference between the initial oscillation frequency and the first frequency is less than or equal to 0.01 MHz.

Optionally, the initial oscillation frequency and the current oscillation frequency are obtained by Ramsey interference experiments.

Based on the same inventive concept, a device for calibrating a frequency of a superconducting qubit is further provided by the present disclosure, and includes: an oscillation frequency obtaining unit configured for applying a microwave signal to the superconducting qubit and obtaining an initial oscillation frequency; a determining unit configured for determining, based on a difference between the initial oscillation frequency and a first frequency, whether the frequency of the superconducting qubit has drifted or not; an adjusting unit configured for adjusting the magnitude of the first voltage accordingly when the frequency of the superconducting qubit has drifted so that the oscillation frequency is constantly approximating the first frequency, until the difference between the current oscillation frequency and the first frequency satisfies a preset convergence condition, and completing calibration; wherein the first frequency is the frequency of the carrier frequency, and the first voltage is the voltage currently applied to the superconducting qubit.

Based on the same inventive concept, a readable storage medium is also provided by the present disclosure, which has computer programs stored thereon, and the computer programs when executed by a processor are capable of implementing the method for calibrating a frequency of a superconducting qubit as described in any of the above characterizations.

Compared with the prior art, the present disclosure has at least one of the following beneficial effects.

1. In the method for calibrating the frequency of the superconducting qubit provided by the present disclosure, applying the microwave signal to the superconducting qubit and obtaining the initial oscillation frequency; then determining, based on the difference between the initial oscillation frequency and the first frequency, whether the frequency of the superconducting qubit has drifted or not; adjusting the magnitude of the first voltage applied on the superconducting qubit when the frequency of the superconducting qubit has drifted so that the oscillation frequency is constantly approximating the first frequency, until the difference between the initial oscillation frequency and the first frequency satisfies the convergence condition. By adjusting the magnitude of the first voltage so that the oscillation frequency is constantly approximating the first frequency, it is possible to adjust the frequency of the superconducting qubit back to a predetermined value, that is, to return the superconducting qubit we selected to the operating point, thus enabling automatic calibration of the frequency of the superconducting qubit that has drifted.

2. By obtaining the estimated value to adjust the first voltage and obtaining the oscillation frequency based on the current estimated value, the estimated value includes the first estimated value and several second estimated values, the second estimated value is obtained by the first slope, the current oscillation frequency, the first frequency, and the current estimated value, it is possible that the oscillation frequency is constantly approximating the first frequency by obtaining the estimated value by continuous iteration according to the magnitude change of the first slope, and the way of using the first slope to iterate can effectively reduce the adjustment number of the first voltage, and can effectively improve the efficiency of automatically calibrating the frequency of the superconducting qubit.

3. In the process of obtaining the first slope by using the first slope to iterate, it is also possible to determine the magnitude of the first difference and the second difference, to update the value of the initial oscillation frequency as the value of the current oscillation frequency when the first difference is greater than the second difference, and to update the value of the initial value as the current estimated value. This setting is to screen out a closer oscillation frequency as the initial oscillation frequency for the next iteration, which can further reduce the adjustment number of the first voltage, and further improve the efficiency of automatically calibrating the frequency of the superconducting qubit.

4. After each adjustment of the first voltage, it is possible to use a Ramsey interference experiments to obtain a real-time oscillation frequency, and the use of the Ramsey interference experiments can effectively reduce the experimental error, thereby improving the accuracy of the frequency of the calibrated superconducting qubit.

The device for calibrating a frequency of a superconducting qubit and a readable storage medium provided by the present disclosure, which belong to the same inventive concept as the method for calibrating a frequency of a superconducting qubit, thus have the same beneficial effect, which will not be repeated herein.

## BRIEF DESCRIPTION OF THE DRAWINGS

FIG. 1 is a flow diagram of a method for calibrating a frequency of a superconducting qubit proposed by an embodiment of the present disclosure;
FIG. 2 is a comparison diagram of the qubit energy spectrum before and after the frequency of the superconducting qubit has drifted;
FIG. 3 is a pulse diagram for Ramsey interference experiments;
FIG. 4 is a result diagram of the Ramsey interference experiments;
FIG. 5 is a diagram for representing drift of the frequency of the superconducting qubit in Embodiment one;
FIG. 6 is a flow diagram of a specific method for calibrating the frequency of the superconducting qubit proposed in Embodiment one;
FIG. 7 is a diagram of a first situation of the drift of the frequency of the superconducting qubit in the Embodiment one;
FIG. 8 is a diagram of a second situation of the drift of the frequency of the superconducting qubit in the Embodiment one;
FIG. 9 is a diagram of a third situation of the drift of the frequency of the superconducting qubit in the Embodiment one;
FIG. 10 is a diagram of a device for calibrating a frequency of a superconducting qubit proposed in Embodiment three;

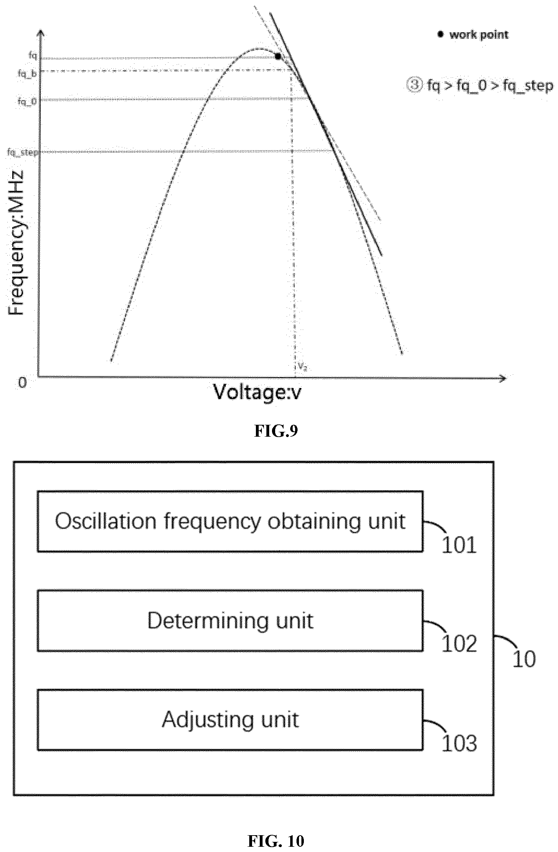

In FIG. 10: 10-device for calibrating frequency of the superconducting qubit, 101-oscillation frequency obtaining unit, 102-determining unit, 103-adjusting unit.

**DETAILED DESCRIPTION**

The following will be described in more detail in conjunction with the schematic diagram of the specific embodiment of the present disclosure. Based on the following description and claims, the advantages and features of the present disclosure will be clearer. It should be noted that the drawings are in a very simplified form and all use imprecise proportions, which are only used to facilitate and clearly assist the purpose of the present public embodiment.

In the description of the present disclosure, it should be understood that the orientation or position relationship indicated by the terms "center", "up", "down", "left", "right" and so on is based on the orientation or position relationship shown in the drawings, and is only for the convenience of describing the content of the present disclosure and simplifying the description, and does not indicate or imply that the device or element referred to must have a specific orientation, constructed and operated in a specific orientation, and therefore cannot be understood as a limitation to the present disclosure.

In addition, terms "first" and "second" are only for descriptive purposes, and should not be understood as indicating or implying relative importance or implying a number of indicated technical features. Therefore, features defined as "first", "second" may expressly or implicitly include at least one of those features. In the description of the present application, "plurality" means at least two, such as two, three, etc., unless expressly and specifically defined otherwise.

In order to better understand the technical solution of the present application, the invention idea of the present application and the related technology involved are briefly described below:

The Ramsey interference experiments refers to the process of applying two $\pi/2$ quantum logic gate operations to a qubit at the time interval $\tau$, applying a read pulse to the qubit after the second $\pi/2$ quantum logic gate operation to obtain the excited state distribution P1 ($\tau$) of the qubit, and changing the time interval $\tau$ to obtain P1 ($\tau$). The result of a typical Ramsey interference experiment is that P1 ($\tau$) satisfies the mathematical model of exponential oscillation attenuation with time interval $\tau$ as follows:

$$P_{fd}\left(\tau\right) = B + A\cos\left(2\pi f_0 \tau\right)e^{-\tau/T_0} \qquad (1)$$

In Equation 1, A and B are the fitting coefficients, $T_0$ is the decoherence time of the qubit, $f_d$ is the carrier frequency of the microwave pulse signal corresponding to the $\pi/2$ quantum logic gate operation, $f_0$ is the oscillation frequency of the qubit, and $f_0$ satisfies the following with the true frequency $f_q$ of that qubit, the carrier frequency of the $\pi/2$ quantum logic gate operation:

$$f_0(f_d) = \left| f_q - f_d \right| \qquad (2)$$

Combining the above with Equation 2, the result of the Ramsey interference experiments can be obtained, i.e., the oscillation frequency of the curve is equal to the difference between the carrier frequency of the quantum logic gate operation and the real frequency of the qubit. Thus, Ramsey interference experiments can be used to obtain not only the decoherence time of the qubit, but also the real frequency of the qubit at the same time.

Under normal operation, there are many root causes of changes in frequency of the superconducting qubit, but the direct causes are all due to changes in magnetic flux. The inventors discovered that when using frequency-adjustable superconducting qubits, it is possible to adjust the operating frequency of superconducting qubits by external magnetic flux. Typically, frequency-adjustable superconducting qubit devices have flux modulation lines, and by applying a voltage to the flux modulation line, the frequency of the superconducting qubit may be changed. It is based on these findings that the inventors consider correcting the magnetic flux by appropriately adjusting the voltage applied to the flux modulation line to correct the magnetic flux, thereby adjusting the frequency of the superconducting qubit back to the set value. By using Ramsey interference experiments, it is possible to precisely obtain the real-time frequencies of superconducting qubits to aid correction.

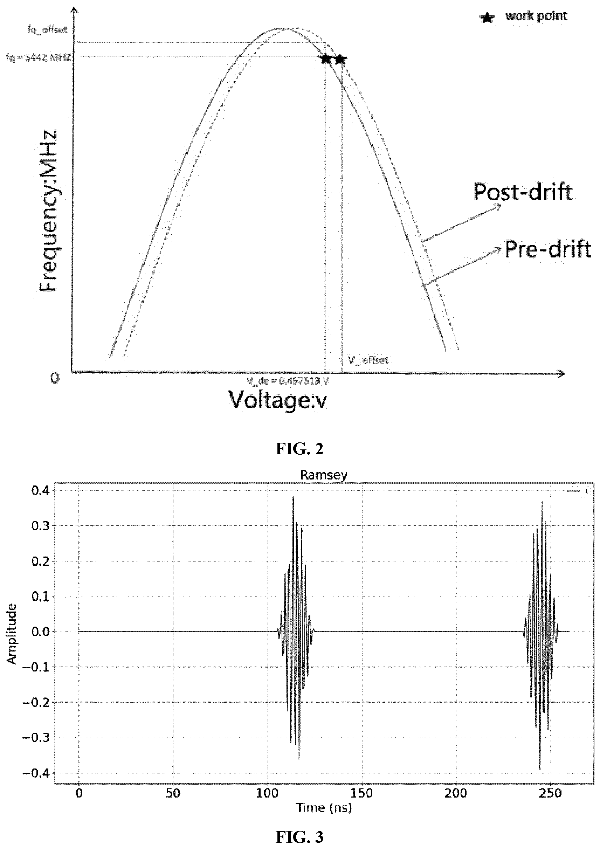

To facilitate the description of the problem, it is possible to abstract the two-dimensional depth diagram of the energy spectrum experiment into a two-dimensional planar diagram as shown in FIG. 2, wherein the solid line represents the relationship between the voltage obtained from the qubit energy spectrum experiment and the frequency of the superconducting qubit, and the dotted line represents the state after the superconducting qubit has drifted (assuming that the drift has occurred to the right). It can be seen that when the drift occurs, the frequency of the superconducting qubit corresponding to V_dc has changed from fq to fq_offset, and therefore, a voltage value V_offset must be reset to make the frequency of the superconducting qubit return to fq, that is, it is necessary to bring the superconducting qubit to work point again.

In order to bring the superconducting qubit to work point again, the qubit energy spectrum experiment can be performed again to fit the function curve represented by the dotted line after the drift. However, the inventors found that it takes a lot of time for the energy spectrum experiment and it is also difficult to achieve very accurate fitting accuracy, which will interfere with the calibration of the final work point. In general, it would be very costly to choose to use Qubit-Spectrum experiments to calibrate the frequency of the superconducting qubit. Therefore, the inventors consider using Ramsey interference experiments to calibrate the work point, which can effectively reduce the experimental error and improve the accuracy of the calibrated frequency of the superconducting qubit.

In the bit coordinate system (Bloch Sphere), if the applied microwave pulse frequency and the frequency of the superconducting qubit are the same frequency, it can be equivalently considered that there is no phase accumulation in the middle, and the result obtained is pure e-exponential oscillation; if the microwave frequency is inconsistent with the frequency of the superconducting qubit, there will be sine oscillation. Please refer to FIG. 3, adding a phase with f as the oscillation frequency on the second $\pi/2$. If the microwave pulse and the bit frequency are the same frequency, the oscillation frequency obtained is f, and if they are different frequencies, the oscillation frequency obtained is f$\pm$ frequency difference; therefore, the actual oscillation frequency is: f_osc=f$\pm$frequency difference. Assuming that the frequency of the superconducting qubit at the work point of a superconducting qubit is fq and the frequency of the microwave pulse is fp (fixed), the frequency difference $\Delta f$ = fq - fp and the oscillation frequency is calculated as:

$$f\_osc = f + \Delta f \tag{3}$$

That is, f_osc=f+(fq-fp); in the case that the superconducting qubit does not drift, fp is equal to fq, theoretical value of the frequency difference $\Delta f=0$, and the value of the oscillation frequency f_osc is equal to f;

When the superconducting bit frequency has drifted, the frequency difference $\Delta f$=fq_offset-fq, and at this time $\Delta f$ is not equal to zero. This condition can be used to determine that the bit frequency has drifted, and the oscillation frequency after the drift is:

$$f\_osc\_offset = f + (fq\_offset - fq).$$

Since the parameters of the previously measured fq-v function have changed, it is impossible to obtain the voltage v_offset corresponding to fq_offset, it is necessary to modify the value of the voltage to try, for example, increase V_dc to V_dc1 (if $\Delta f < 0$, it is necessary to reduce the voltage value), and under the voltage value of V_dc1, f_osc1 may be measured by the Ramsey interference experiments, which is obtained from the previous calculation formula of oscillation frequency:

$$f\_osc1 = f + (fq1 - fq) \tag{4}$$

Although the value of fq1 is not obtained, it is obtained by subtracting Equation 4 from Equation 3:

$$f\_osc - f\_osc1 = fq - fq1 \tag{5}$$

Therefore, the drift value of the frequency of the superconducting qubit can be calculated by the difference in the oscillation frequency, in addition, f_osc1 - f = fq1 - fq;

Therefore, the oscillation frequency can be used instead of the frequency of the bit itself for calculation, and the following formula can be used as a calibration convergence condition for specific applications:

$$|f\_osc - f| \leqslant 0.01 \mathrm{MHz}$$

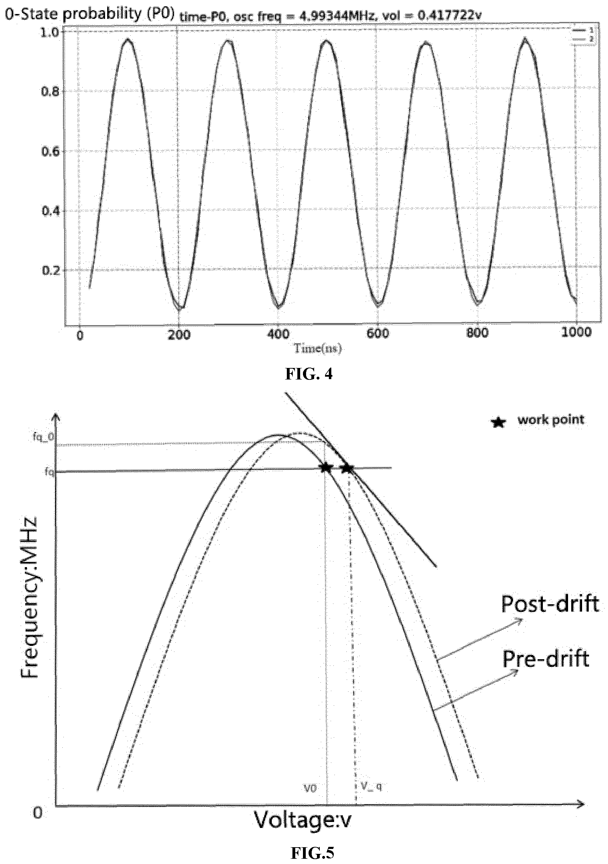

Referring to FIG. 4, assuming that the given f is 5MHz, if the oscillation frequency f_osc measured by the Ramsey interference experiments is 4.99344MHz, the bit frequency can be considered to be at the work point, and because the difference between f_osc and f is within 0.01MHz, the preset convergence condition are met.

**Embodiment One**

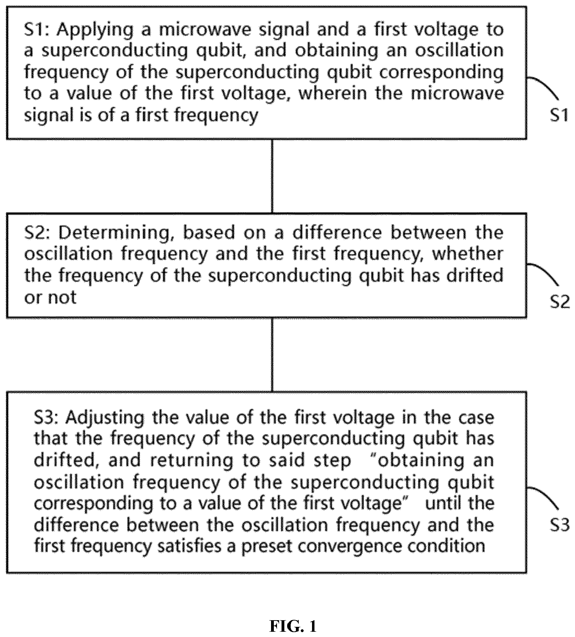

Based on the above inventive idea, the present embodiment proposes a method for calibrating a frequency of a superconducting qubit. Please refer to FIG. 1, the method for calibrating a frequency of a superconducting qubit includes the following steps:

S1: applying a microwave signal and a first voltage to a superconducting qubit and obtaining an oscillation frequency of the superconducting qubit corresponding to a value of the first voltage, wherein the microwave signal is of a first frequency;

S2: determining, based on a difference between the oscillation frequency and the first frequency, whether the frequency of the superconducting qubit has drifted or not;

S3: adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition.

Different from the prior art, in the method for calibrating a frequency of a superconducting qubit proposed by the embodiment of present disclosure, applying the microwave signal to the superconducting qubit and obtaining the initial oscillation frequency; then determining, based on the difference between the initial oscillation frequency and the first frequency, whether the frequency of the superconducting qubit has drifted or not; adjusting the magnitude of the first voltage applied on the superconducting qubit when the frequency of the superconducting qubit has drifted so that the oscillation frequency is constantly approximating the first frequency, until the difference between the initial oscillation frequency and the first frequency satisfies the convergence condition. By adjusting the magnitude of the first voltage so that the oscillation frequency is constantly approximating the first frequency, it is possible to adjust the frequency of the superconducting qubit back to a predetermined value, that is, to return the superconducting qubit we selected to the operating point, thus enabling automatic calibration of the frequency of the superconducting qubit that has drifted. It should be noted that, in the embodiment of the present disclosure, the initial oscillation frequency and the current oscillation frequency are preferably obtained through the Ramsey interference experiment, but it does not mean that the initial oscillation frequency and the current oscillation frequency can only be obtained through the Ramsey interference experiments. In other embodiments, other energy spectrum measurement experiments can also be implemented, which is not limited herein.

Specifically, the step S2 may specifically include:

S21: determining that the frequency of the superconducting qubit has drifted when an absolute value of the difference between the initial oscillation frequency and the first frequency is greater than the first threshold; wherein the first threshold is a pre-configured value.

S22: determining that the frequency of the superconducting qubit has not drifted when the absolute value of the difference between the initial oscillation frequency and the first frequency is less than or equal to the first threshold.

It can be understood that the setting of the first threshold may generally refer to the convergence condition. In the present embodiment, the first threshold is 0.01 MHz, and in other embodiments, the adjustment may be selected according to actual needs, which is not limited herein.

Further, please refer to FIG. 5, (V_q, fq) represents a work point after the superconducting qubit drifts, and fq_0 represents a frequency value corresponding to the voltage after the superconducting qubit drifts (before calibration). Since the specific parameters of the drifted curve function (shown by the dotted line) are unknown, V_q cannot be obtained when fq is known, so the problem needs to be transformed.

Assuming that the tangent slope at work point (V_q, fq) is k_q, then work point (V_q, fq) must be on a line with a slope of k_q. According to the mathematical principles of derivatives, the derivative of the function f(x) at point x0 can be defined as: the limit of $\dfrac{f(x)-f(x_0)}{x-x_0}$ when the variable x in the definition domain approaches x0, i.e.:

$$f'(x_0) = \lim_{x \to x_0} \frac{f(x)-f(x_0)}{x-x_0}$$

$$(7)$$

Therefore, the problem to be solved is converted into: finding a point (V2, f_b) on the drifted curve, when (V2, f_b) is close enough to (V_q, fq), the slope at this point is infinitely close to k_q, so this point can be considered as the work point of the bit.

According to Formula 3, tangent slope can be calculated with at least two sets of coordinates. If the voltage is shifted by a small increment so that the first voltage becomes V1, the tangent slope at this point is approximately equivalent to:

$$k=(fq\_step - fq\_0)/(V1 - V0) \qquad (8)$$

According to the preceding, the exact parameters of the function after the drift are unknown, therefore, neither fq_step nor fq_0 can be known, but they can be derived from Equation 5:

$$f1 - f0 = fq\_step - fq\_0 \qquad (9)$$

$$k=(f1 - f0)/(V1 - V0) \qquad (10)$$

Wherein, the oscillation frequency f1 is measured by Ramsey interference experiments after said first voltage is adjusted to V1; f0 is the initial oscillation frequency measured by Ramsey interference experiments using the initial value V0. Therefore, the approximate slope can be calculated by only measuring the oscillation frequency by Ramsey interference experiments. It is also known from Equation 6 that the closer f_osc is to f, the closer the frequency of the superconducting qubit corresponding to the voltage value at this point is to the operating frequency of the bit. Thus, by taking f as a reference and then comparing the difference between f_osc and f at each iteration, the calibration of said superconducting qubits is considered to have been completed when the absolute value of this difference is less than or equal to 0.01 MHz. It is understood that, in the present embodiment, the convergence condition may be set such that the absolute value of the difference between the current oscillation frequency and the first frequency f is less than or equal to 0.01MHz. In other embodiments, the convergence condition may also be other cases, for example, in certain application scenarios with high requirements for frequency of the superconducting qubit, the convergence condition may be set such that the absolute value of the difference between the current oscillation frequency and the first frequency f is less than or equal to 0.001 MHz; while in some application scenarios with lower requirements for the frequency of the superconducting qubit, the convergence condition may be set such that the absolute value of the difference between the current oscillation frequency and the first frequency f is less than or equal to 0.02 MHz. There are many other cases for the convergence condition, which are not described here one by one, and can be selected according to actual needs or actual application scenarios.

Based on this, in step S3 of the present embodiment, regarding how to adjust the magnitude of the first voltage in the case that the frequency of the superconducting qubit has drifted, it is preferable to adjust the first voltage by obtaining a estimated value and obtain the current oscillation frequency based on the current estimated value until the difference between the current oscillation frequency and the first frequency satisfies the convergence condition;

Specifically, during each adjusting of the value of the first voltage, a current estimated value and a current oscillation frequency corresponding to the current estimated value are output, wherein said "adjusting the value of the first voltage", includes:

> obtaining a number n of current completions of adjusting the value of the first voltage;
> obtaining an initial value $V_0$ of the first voltage if the number n is less than a first preset value;
> adjusting the value of the first voltage to a first estimated value = $V_0 + \Delta V$ according to the initial value $V_0$ and a preset adjustment amplitude $\Delta V$;
> and updating the initial value $V_0$ of the first voltage as the first estimated value when the number n is less than the preset number minus 1.

It can be understood that the value of the adjustment amplitude $\Delta V$ during the obtaining of the first estimated value may be a positive value or a negative value, for example, if the difference between the initial oscillation frequency corresponding to the initial value $V_0$ and the first frequency is greater than zero according to the situation shown in FIG. 2, the value of the adjustment amplitude $\Delta V$ is a positive value, and when the difference between the initial oscillation frequency corresponding to the initial value $V_0$ and the first frequency is less than zero, the value of the adjustment amplitude ΔV is a negative value. Therefore, the value of the adjustment amplitude ΔV specifically needs to be selected according to the initial oscillation frequency corresponding to the initial value V0, which is not limited herein.

The estimated value is also obtained in the following ways:
performing several secondary adjustment processes to obtain several second estimated values;

Wherein the secondary adjustment process is configured to obtain the second estimated value based on the first slope, the current oscillation frequency, the first frequency, and the current estimated value, and the first slope is the slope of the connection between two points on the qubit energy spectrum corresponding to the initial value and the first voltage.

By obtaining the estimated value to adjust the first voltage and obtaining the oscillation frequency based on the current estimated value, the estimated value includes the first estimated value and several second estimated values, the second estimated value is obtained by the first slope, the current oscillation frequency, the first frequency, and the current estimated value, it is possible that the oscillation frequency is constantly approximating the first frequency by obtaining the estimated value by continuous iteration according to the magnitude change of the first slope, and the way of using the first slope to iterate can effectively reduce the adjustment number of the first voltage, and can effectively improve the efficiency of automatically calibrating the frequency of the superconducting qubit.

Specifically, the first slope is k, and the k can be obtained according to Equation 11:

$$k = \frac{f_1 - f_0}{V_1 - V_0} \tag{11}$$

Wherein $f_1$ is the current oscillation frequency, $f_0$ is the initial oscillation frequency, $V_1$ is the current estimated value, and $V_0$ is the initial value.

Further, the secondary adjustment process may further include:
determining the magnitude of the first difference and the second difference; wherein the first difference is the absolute value of the difference between the oscillation frequency obtained last time and the first frequency, and the second difference is the absolute value of the difference between the current oscillation frequency and the first frequency;

When the first difference is greater than the second difference, the value of the initial oscillation frequency is updated to the value of the current oscillation frequency, and the value of the initial value is updated to the current estimated value.

In the process of obtaining the first slope by using the first slope to iterate, it is also possible to determine the magnitude of the first difference and the second difference, to update the value of the initial oscillation frequency as the value of the current oscillation frequency when the first difference is greater than the second difference, and to update the value of the initial value as the current estimated value. This setting is to screen out a closer oscillation frequency as the initial oscillation frequency for the next iteration, which can further reduce the adjustment number of the first voltage, and further improve the efficiency of automatically calibrating the frequency of the superconducting qubit.

Specifically, the second estimated value is $V_2$, and the $V_2$ is obtained according to Equation 12:

$$V_2 = V_1 + \frac{f - f_1}{k} \tag{12}$$

Wherein f is the first frequency.

By combining Equation 11 and Equation 12, it can be obtained that:

$$V_2 = V_1 + \frac{V_1 - V_0}{f_1 - f_0} \times (f - f_1)$$

Specifically, said "adjusting the value of the first voltage", further includes:

obtaining the initial value $V_0$ and the current estimated value $V_1$ as well as an initial oscillation frequency $f_0$ corresponding to the initial value $V_0$, and the current oscillation frequency $f_1$ if the number n is greater than or equal to the first preset value;

based on the initial value $V_0$ and the current estimated value $V_1$ as well as the initial oscillation frequency $f_0$ and the current oscillation frequency $f_1$, adjusting the value of the first voltage to a second estimated value $V_2$:

$$V_2 = V_1 + \frac{V_1 - V_0}{f_1 - f_0} \times (f - f_1)$$

From the above description of the secondary adjustment process, it is clear that said "adjusting the value of the first voltage", further includes:

obtaining an oscillation frequency $f_2$ corresponding to the second estimated value $V_2$;
determining if $| f_2 - f |$ is less than $| f_1 - f |$ or not;
if yes, updating the initial value $V_0$ to $V_2$, and updating the initial oscillation frequency $f_0$ to $f_2$.

Further, in order to avoid wasting computing resources, an adjustment number threshold may be set, that is, a threshold is set for the iteration number, and when the iteration number exceeds a certain threshold, it may be considered that the result has converged or has fallen into a local optimal solution, and the solution obtained at this time may be considered to be the optimal solution. In particular, the method for calibrating a frequency of a superconducting qubit further includes the following steps:

setting an adjustment number threshold;
determining, before each adjusting of the first voltage, whether a current adjustment number exceeds the adjustment number threshold or not;
if yes, selecting an oscillation frequency most approximate to the first frequency and a corresponding first voltage as a calibration result, and completing calibration;
if not, adjusting the first voltage

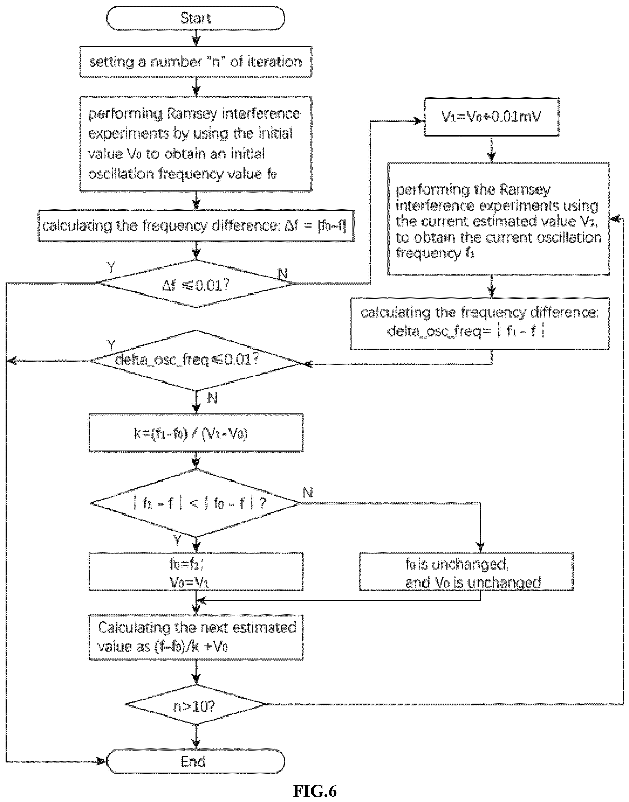

By combining the method of iterating to obtain the estimated value by using the first slope K in the present embodiment, referring to FIG. 6, a specific method for calibrating the frequency of the superconducting qubit is proposed as follows:

Step 1, performing Ramsey interference experiments by using the initial value $V_0$ to obtain the initial oscillation frequency value $f_0$;
Step 2: calculating the frequency difference: $\Delta f = |f_0 - f|$, and determining whether $\Delta f$ is less than or equal to 0.01 MHz; if the condition is met, ending the calibration method;
Step 3: adding an offset of 0.1 mV on the basis of the initial value $V_0$ to obtain the first estimated value $V_1$;
Step 4, performing the Ramsey interference experiments by using $V_1$ to obtain the oscillation frequency $f_1$;
Step 5: calculating the frequency difference: $\Delta f = |f_1 - f|$, and determining whether $\Delta f$ is less than or equal to 0.01 MHz; if the condition is met, ending the calibration method;
Step 6: calculating the slope $K = (f_1 - f_0)/(V_1 - V_0)$;
Step 7: determining the absolute value of the difference between $f_0$ and $f_1$ and f, and selecting a closer oscillation frequency as the initial frequency of the next iteration; that is, if $|f_1 - f| < |f_0 - f|$, then $f_0 = f_1$, and $V_0 = V_1$; if $|f_1 - f| > |f_0 - f|$, then $f_0$ is unchanged, and $V_0$ is unchanged;
Step 8: calculating the next estimated value $(f - f_1)/k + V_1$;
Step 9: determining whether the iteration number is exceeded, and if yes, ending the calibration method; otherwise, returning and executing the Step 4.

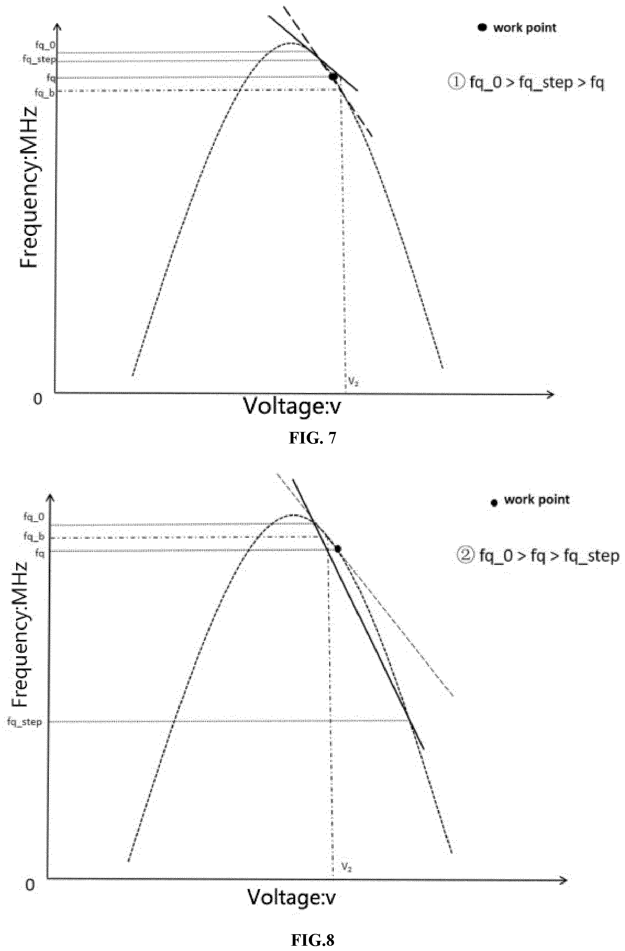

In order to facilitate the understanding of those skilled in the art, the technical solution of the present application is described in detail below in conjunction with some examples.
Specifically, referring to FIGS. 7 to 9, the calibration cases in which the frequency of the superconducting qubit drifts can be roughly divided into three cases according to the work point positions of said superconducting qubits. Suppose that fq_Step denotes the value of the frequency of the superconducting qubit after adjusting the voltage $V_1$, $V_2$ denotes the value of the voltage calculated according to the first slope, and fq_b denotes the value of the frequency of the superconducting qubit derived according to $V_2$. A Ramsey interference experiment is first performed without changing the voltage to derive the initial oscillation frequency $f_0$ after the occurrence of drift.
Case 1: Referring to FIG. 7, after the first voltage adjustment, both the frequency fq_0 before the uncalibrated and the frequency fq_Step after the first voltage adjustment are greater than the desired work point frequency fq, i.e.

fq_0 > fq_Step > fq:

Referring further to FIG. 7, an offset of ΔV is added to the initial voltage $V_0$ so that the said first voltage becomes $V_1$, and then a Ramsey interference experiment is performed to determine the oscillation frequency $f_1$. Using Equation 5, it can be derived that:

$$fq\_Step \, - fq\_0 = f_1 - f_0;$$

$$k = （f_1 - f_0） / （V_1 - V_0） \, ;$$

Taking f as the base and assuming that the said first slope is the sought slope, then:

$$fq - fq\_Step / V_2 - V_1 = k;$$

$$V_2 = （fq - fq\_Step） / k + V_1;$$

$$V_2 = （f - f1） / k + V_1;$$

Then, the Ramsey interference experiment is performed again at this time by using the estimated value $V_2$ so as to conduct Ramsey interference experiment again so as to find out the oscillation frequency $f_2$. It can be seen from the above figure that fq_b is actually lower than fq more, so the difference $f - f_2$ between $f_2$ and f > 0.01 (not according to the figure, the actual calculation is also the same). Then it can be determined that $(V_2, fq\_b)$ is not the work point to be found, and the next iteration is needed. At the same time, it can be determined that the slope k is large at this point since the slope of the point on the left at x0 is greater than the slope at x0 by the properties of a convex function.

$V_1$ is re-selected as the starting point (due to fq_Step being closer to fq than fq_0) still with f as the base. It should be noted that the slope k at this time has been updated to: $k=(f_2 - f_1)/(V_2 - V_1)$; as shown by the dashed line in FIG. 7, it can be seen that the slope has become smaller, indicating that it is converging in the right direction, and one can assume that the slope is the desired slope and calculate the next estimated value $V_3$ from k;

$$V_3 = (fq - f\_b)/k + V_2 \, ;$$

$$V_3 = (f - f_2 )/k + V_2 \, ;$$

At this point, the estimated value is already moving in the direction of the voltage value corresponding to fq and has begun to converge.

Case 2: Referring to FIG. 8, after the first voltage adjustment, the desired work point frequency fq is between the frequency fq_0 before the uncalibrated and the frequency fq_Step after the first voltage adjustment, i.e. fq_0 > fq > fq_Step:

Referring further to FIG. 8, an offset of ΔV is added to the initial voltage $V_0$ so that the said first voltage becomes $V_1$, and then a Ramsey interference experiment is performed to determine the oscillation frequency $f_1$. Using Equation 5, it can be derived that:

$$fq\_Step \, - fq\_0 = f_1 - f_0;$$

$$k = （f_1 - f_0） / （V_1 - V_0） \, ;$$

Taking f as the base and assuming that the said first slope is the sought slope, then:

$$fq - fq\_Step / V_2 - V_1 = k;$$

$$V_2 = (fq - fq\_Step) / k + V_1;$$

$$V_2 = (f - f1) / k + V_1;$$

Then, the Ramsey interference experiment is performed again at this time by using the estimated value $V_2$ so as to conduct Ramsey interference experiment again so as to find out the oscillation frequency $f_2$. It can be seen from the above figure that fq_b is actually greater than fq more, so the difference $f-f_2$ between $f_2$ and f <-0.01 (not according to the figure, the actual calculation is also the same). Then it can be determined that $(V_2, fq\_b)$ is not the work point to be found, and the next iteration is needed. At the same time, it can be determined that the slope k is small at this point since the slope of the point on the left at x0 is greater than the slope at x0 by the properties of a convex function.

$V_0$ is re-selected as the starting point (due to fq_0 being closer to fq than fq_Step) still with f as the base. It should be noted that the slope k at this time has been updated to: $k=(f_2 -f_0)/(V_2 -V_0)$; as shown by the dashed line in FIG. 8, it can be seen that the slope has become larger, indicating that it is converging in the right direction, and one can assume that the slope is the desired slope and calculate the next estimated value $V_3$ from k;

$$V_3 = (fq - f\_b)/k + V_2 ;$$

$$V_3 = (f - f_2 )/k + V_2 ;$$

At this point, the estimated value is already moving in the direction of the voltage value corresponding to fq and has begun to converge.

It should be noted that in several examples enumerated in the present embodiment, the work points of the superconducting qubit are on the right side of an equilibrium point (extreme point of the waveform), but in practical applications, there are many other cases. For example, given the symmetry, it is actually possible that, although the frequency of the superconducting qubit does not drift by much, the work voltage of the superconducting qubit was originally to the right of the equilibrium point, but drifted to the left of the equilibrium point. Also, given the periodicity, it is actually possible that the work voltage of the superconducting qubit drifts to a certain value in the adjacent period. It is also possible that a combination of these two conditions may occur, but in either case, the adjustment principle may be calibrated according to the calibration method proposed in the present application. There are many other cases, and the calibration method of frequency of the superconducting qubit proposed in this application is also applicable to those, which will not be repeated herein.

**Embodiment Two**

The difference between the present embodiment and Embodiment One lies in the adjustment method of the first voltage. In the present embodiment, the specific adjustment process of the first voltage is as follows: in any process of during each adjusting of the magnitude of the first voltage, if the magnitude of the current oscillation frequency varies in a direction away from the magnitude of the first frequency after the first voltage is adjusted in a first direction, adjusting the first voltage in a second direction during the next adjusting of the magnitude of the first voltage;

if the magnitude of the current oscillation frequency varies in a direction approximating the magnitude of the first frequency after the first voltage is adjusted in the first direction, adjusting the first voltage in the first direction during the next adjusting of the magnitude of the first voltage; wherein the first direction is opposite to the second direction.

Further, adjusting the first voltage according to voltage values of the same magnitude or different magnitudes during each adjusting of the value of the first voltage. In each adjustment of the first voltage, it is possible to adjust the magnitude of the first voltage accordingly according to the magnitude of the difference between the current oscillation frequency and the first frequency, for example, increasing the magnitude of adjusting the first voltage in the case that the value of the oscillation frequency away from the first frequency is relatively large, and decreasing the magnitude of adjusting the first voltage in the case that the value of the oscillation frequency away from the first frequency is relatively small. By adjusting the first voltage in this way, it is possible to effectively reduce the adjustment number while ensuring accuracy. As for details of other steps of the method for calibrating the frequency of the superconducting qubit in the present embodiment, reference may be made to the method described in Embodiment one, which will not be repeated herein.

By compared with the technical solution of the Embodiment one, although the method for calibrating a frequency of a superconducting qubit of the present embodiment has a larger adjustment number of the first voltage than the method in Embodiment One, the present embodiment has a simpler process, and has a simpler algorithm compared with the Embodiment One.

**Embodiment Three**

Please refer to FIG. 10, based on the same inventive concept, a device 10 for calibrating a frequency of a superconducting qubit is provided by the present embodiment, and includes:

an oscillation frequency obtaining unit 101 configured for applying a first voltage and a microwave signal being a first frequency f to the superconducting qubit and obtaining an oscillation frequency of the superconducting qubit corresponding to a value of the first voltage;

a determining unit 102 configured for determining, based on a difference between the oscillation frequency and the first frequency, whether the frequency of the superconducting qubit has drifted or not;

an adjusting unit 103 configured for adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition.

It should be understood that the oscillation frequency obtaining unit 101, the determining unit 102 and the adjusting unit 103 may be combined and implemented in one device, or any one of the modules may be split into multiple sub-modules, or, the at least part of the functions of one or more modules of the oscillation frequency obtaining unit 101, the determining unit 102 and the adjusting unit 103 may be combined with at least part of the functions of other modules and implemented in one function module. According to an embodiment of the present disclosure, at least one of the oscillation frequency obtaining unit 101, the determining unit 102, and the adjusting unit 103 may be at least partially implemented as a hardware circuit, such as a field programmable gate array (FPGA), programmable logic array (PLA), system on a chip, system on a substrate, system on a package, application specific integrated circuit (ASIC), or may be implemented by hardware or firmware in any other reasonable way of integrating or packaging circuits, or may be implemented by an appropriate combination of software, hardware and firmware. Alternatively, at least one of the oscillation frequency obtaining unit 101, the determining unit 102, and the adjusting unit 103 may be at least partially implemented as a computer program module, and when the program is run by a computer, the functions of the corresponding modules may be performed.

**Embodiment Four**

Based on the same inventive concept, a readable storage medium is provided by the present embodiment, which has computer programs stored thereon, and the computer programs when executed by a processor are capable of implementing the method for calibrating a frequency of a superconducting qubit as described in any of the above characterizations.

The computer readable storage medium may be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. Computer readable program instructions described herein may be downloaded to respective computing/processing devices from a computer readable storage medium or to an external computer or external storage device via a network, for example, the Internet, a local area network, a wide area network and/or a wireless network. The network may include copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, systems, and computer program products according to embodiments of the invention. It will be understood that each block of the flowchart illustrations and/or block diagrams, and combinations of blocks in the flowchart illustrations and/or block diagrams, may be implemented by computer readable program instructions. These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein includes an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

In summary, the present disclosure has at least one of the following beneficial effects.

1. In the method for calibrating the frequency of a superconducting qubit provided by the present disclosure, applying the microwave signal to the superconducting qubit and obtaining the initial oscillation frequency; then determining, based on the difference between the initial oscillation frequency and the first frequency, whether the frequency of a superconducting qubit has drifted or not; adjusting the magnitude of the first voltage applied on the superconducting qubit when the frequency of a superconducting qubit has drifted so that the oscillation frequency is constantly approximating the first frequency, until the difference between the initial oscillation frequency and the first frequency satisfies the convergence condition. By adjusting the magnitude of the first voltage so that the oscillation frequency is constantly approximating the first frequency, it is possible to adjust the frequency of a superconducting qubit back to a predetermined value, that is, to return the superconducting qubit we selected to the operating point, thus enabling automatic calibration of the frequency of a superconducting qubit that has drifted.

2. By obtaining the estimated value to adjust the first voltage and obtaining the oscillation frequency based on the current estimated value, the estimated value includes the first estimated value and several second estimated values, the second estimated value is obtained by the first slope, the current oscillation frequency, the first frequency, and the current estimated value, it is possible that the oscillation frequency is constantly approximating the first frequency by obtaining the estimated value by continuous iteration according to the magnitude change of the first slope, and the way of using the first slope to iterate can effectively reduce the adjustment number of the first voltage, and can effectively improve the efficiency of automatically calibrating the frequency of a superconducting qubit.

3. In the process of obtaining the first slope by using the first slope to iterate, it is also possible to determine the magnitude of the first difference and the second difference, to update the value of the initial oscillation frequency as the value of the current oscillation frequency when the first difference is greater than the second difference, and to update the value of the initial value as the current estimated value. This setting is to screen out a closer oscillation frequency as the initial oscillation frequency for the next iteration, which can further reduce the adjustment number of the first voltage, and further improve the efficiency of automatically calibrating the frequency of a superconducting qubit.

4. After each adjustment of the first voltage, it is possible to use a Ramsey interference experiments to obtain a real-time oscillation frequency, and the use of the Ramsey interference experiments can effectively reduce the experimental error, thereby improving the accuracy of the frequency of the calibrated superconducting qubit.

The device for calibrating a frequency of a superconducting qubit and a readable storage medium provided by the present disclosure, which belong to the same inventive concept as the method for calibrating a frequency of a superconducting qubit, thus have the same beneficial effect, which will not be repeated herein.

In the description of the present specification, the description of the terms "one embodiment", "some embodiments", "examples" or "specific examples" and the like refers to at least one embodiment or example included in the present disclosure in conjunction with the specific features, structures, materials or characteristics described in the present embodiment or example. In the present specification, the schematic expression of the above terms does not have to refer to the same embodiment or example. Further, the specific features, structures, materials or characteristics described may be combined in a suitable manner in any one or more embodiments. Further, those skilled in the art may be joined and combined with different embodiments or examples described in the present specification.

The foregoing is only a preferred embodiment of the present disclosure and does not have any limiting effect on the present disclosure. Any technical person in the art who belongs to the field of the present disclosure, within the scope of the technical solution that does not depart from the present disclosure, makes any form of equivalent replacement or modification of the technical solution and technical content disclosed in the present disclosure, which is the content of the technical solution that is not separated from the present disclosure, and still falls within the scope of protection of the present disclosure.

**Claims**

1. A method for calibrating a frequency of a superconducting qubit, comprising:

   applying a microwave signal and a first voltage to a superconducting qubit, and obtaining an oscillation frequency of the superconducting qubit corresponding to a value of the first voltage, wherein the microwave signal is of a first frequency;
   determining, based on a difference between the oscillation frequency and the first frequency, whether the frequency of the superconducting qubit has drifted or not;
   adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition.

2. The method of claim 1 for calibrating a frequency of a superconducting qubit, wherein during each adjusting of the value of the first voltage, a current estimated value and a current oscillation frequency corresponding to the current estimated value are output,
   wherein said "adjusting the value of the first voltage" comprises:

   obtaining a number n of current completions of adjusting the value of the first voltage;
   obtaining an initial value $V_0$ of the first voltage if the number n is less than a first preset value;
   adjusting the value of the first voltage to a first estimated value = $V_0 + \Delta V$ according to the initial value $V_0$ and a preset adjustment amplitude $\Delta V$; and
   updating the initial value $V_0$ of the first voltage as the first estimated value when the number n is less than the preset number minus 1.

3. The method of claim 2 for calibrating a frequency of a superconducting qubit, wherein said "adjusting the value of the first voltage" further comprises:

   obtaining the initial value $V_0$ and the current estimated value $V_1$ as well as an initial oscillation frequency $f_0$ corresponding to the initial value $V_0$, and the current oscillation frequency $f_1$, if the number n is greater than or equal to the first preset value;
based on the initial value $V_0$ and the current estimated value $V_1$ as well as the initial oscillation frequency $f_0$ and the current oscillation frequency $f_1$, adjusting the value of the first voltage to a second estimated value $V_2$:

$$V_2 = V_1 + \frac{V_1 - V_0}{f_1 - f_0} \times (f - f_1)$$

.

4. The method of claim 3 for calibrating a frequency of a superconducting qubit, wherein said "adjusting the value of the first voltage", further comprises:

obtaining an oscillation frequency $f_2$ corresponding to the second estimated value $V_2$;
determining if $|f_{2\text{-}f}|$ is less than $|f_{1\text{-}f}|$ or not;
if yes, updating the initial value $V_0$ to $V_2$, and updating the initial oscillation frequency $f_0$ to fz.

5. The method of claim 1 for calibrating a frequency of a superconducting qubit, wherein during each adjusting of the magnitude of the first voltage, if the magnitude of the current oscillation frequency varies in a direction away from the magnitude of the first frequency after the first voltage is adjusted in a first direction, adjusting the first voltage in a second direction during the next adjusting of the magnitude of the first voltage;

if the magnitude of the current oscillation frequency varies in a direction approximating the magnitude of the first frequency after the first voltage is adjusted in the first direction, adjusting the first voltage in the first direction during the next adjusting of the magnitude of the first voltage;
wherein the first direction is opposite to the second direction.

6. The method of claim 5 for calibrating a frequency of a superconducting qubit, wherein adjusting the first voltage according to voltage values of the same magnitude or different magnitudes during each adjusting of the value of the first voltage.

7. The method of claim 1 for calibrating a frequency of a superconducting qubit, further comprising:

setting an adjustment number threshold;
determining, before each adjusting of the first voltage, whether a current adjustment number exceeds the adjustment number threshold or not;
if yes, selecting an oscillation frequency most approximate to the first frequency and a corresponding first voltage as a calibration result, and completing calibration;
if not, adjusting the first voltage.

8. The method of claim 1 for calibrating a frequency of a superconducting qubit, wherein said "determining, based on a difference between the initial oscillation frequency and the first frequency, whether the frequency of the superconducting qubit has drifted or not", comprises:

determining that the frequency of the superconducting qubit has drifted when an absolute value of the difference between the initial oscillation frequency and the first frequency is greater than a first threshold;
determining that the frequency of the superconducting qubit has not drifted when the absolute value of the difference between the initial oscillation frequency and the first frequency is less than or equal to the first threshold;
wherein the first threshold is a pre-configured value.

9. The method of claim 1 for calibrating a frequency of a superconducting qubit, wherein the convergence condition comprises:
an absolute value of the difference between the initial oscillation frequency and the first frequency is less than or equal to 0.01 MHz.

10. The method of claim 1 for calibrating a frequency of a superconducting qubit, wherein the initial oscillation frequency and the current oscillation frequency are obtained by Ramsey interference experiments.

11. A device for calibrating a frequency of a superconducting qubit, the device comprising:

**EP 4 257 990 A1**

an oscillation frequency obtaining unit configured for applying a microwave signal and a first voltage to a superconducting qubit and obtaining an oscillation frequency of the superconducting qubit corresponding to a value of the first voltage, wherein the microwave signal is of a first frequency;
a determining unit configured for determining, based on a difference between the oscillation frequency and the first frequency, whether the frequency of the superconducting qubit has drifted or not;
an adjusting unit configured for adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition.

12. A readable storage medium having a computer program stored thereon, wherein the computer program, when executed by a processor, is capable of implementing the method of any one of claims 1 to 10 for calibrating a frequency of a superconducting qubit.

S1: Applying a microwave signal and a first voltage to a superconducting qubit, and obtaining an oscillation frequency of the superconducting qubit corresponding to a value of the first voltage, wherein the microwave signal is of a first frequency

S1

S2: Determining, based on a difference between the oscillation frequency and the first frequency, whether the frequency of the superconducting qubit has drifted or not

S2

S3: Adjusting the value of the first voltage in the case that the frequency of the superconducting qubit has drifted, and returning to said step "obtaining an oscillation frequency of the superconducting qubit corresponding to a value of the first voltage" until the difference between the oscillation frequency and the first frequency satisfies a preset convergence condition

S3

**FIG. 1**

**FIG. 2**

**FIG. 3**

**FIG. 4**

**FIG.5**

Start

setting a number "n" of iteration

performing Ramsey interference experiments by using the initial value $V_0$ to obtain an initial oscillation frequency value $f_0$

calculating the frequency difference: $\Delta f = |f_0 - f|$

$\Delta f \leqslant 0.01$?  Y / N

$V_1 = V_0 + 0.01mV$

performing the Ramsey interference experiments using the current estimated value $V_1$, to obtain the current oscillation frequency $f_1$

calculating the frequency difference: delta_osc_freq = $|f_1 - f|$

delta_osc_freq $\leqslant 0.01$?  Y / N

$k = (f_1 - f_0) / (V_1 - V_0)$

$|f_1 - f| < |f_0 - f|$?  Y / N

$f_0 = f_1$; $V_0 = V_1$

$f_0$ is unchanged, and $V_0$ is unchanged

Calculating the next estimated value as $(f - f_0)/k + V_0$

$n > 10$?

End

**FIG.6**

**FIG. 7**

**FIG.8**

**FIG.9**

**FIG. 10**

23

# EP 4 257 990 A1

## INTERNATIONAL SEARCH REPORT

| | |
|---|---|
| | International application No. |
| | **PCT/CN2021/135511** |

**A.    CLASSIFICATION OF SUBJECT MATTER**

G01R 23/02(2006.01)i

According to International Patent Classification (IPC) or to both national classification and IPC

**B.    FIELDS SEARCHED**

Minimum documentation searched (classification system followed by classification symbols)

G01R23

Documentation searched other than minimum documentation to the extent that such documents are included in the fields searched

Electronic data base consulted during the international search (name of data base and, where practicable, search terms used)

CNABS, CNTXT, CNKI, VEN: 量子, 比特, 校准, 校正, 频率, 振荡, 漂移, 偏移, RAMSEY, QUANTUM, QUBIT, FREQUENCY, SHIFT, OFFSET, DRIFT, CALIBRATION

**C.    DOCUMENTS CONSIDERED TO BE RELEVANT**

| Category* | Citation of document, with indication, where appropriate, of the relevant passages | Relevant to claim No. |
|---|---|---|
| X | CN 111523671 A (ALIBABA GROUP HOLDING LIMITED) 11 August 2020 (2020-08-11) description, paragraphs 41-51, 127, figure 2 | 1-2, 7-12 |
| A | CN 109406875 A (HEFEI ORIGIN QUANTUM COMPUTING TECHNOLOGY CO., LTD.) 01 March 2019 (2019-03-01) entire document | 1-12 |
| A | CN 111722084 A (JINAN INSPUR HIGH-TECH INVESTMENT DEVELOPMENT CO., LTD.) 29 September 2020 (2020-09-29) entire document | 1-12 |
| A | CN 110488091 A (HEFEI ORIGIN QUANTUM COMPUTING TECHNOLOGY CO., LTD.) 22 November 2019 (2019-11-22) entire document | 1-12 |
| A | CN 110612540 A (GOOGLE INC.) 24 December 2019 (2019-12-24) entire document | 1-12 |
| A | CN 102201811 A (JIANGHAN UNIVERSITY) 28 September 2011 (2011-09-28) entire document | 1-12 |
| A | US 2020183768 A1 (D WAVE SYSTEMS INC.) 11 June 2020 (2020-06-11) entire document | 1-12 |

☑ Further documents are listed in the continuation of Box C.      ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **21 February 2022** | **03 March 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2021/135511** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2018260732 A1 (RIGETTI & CO. INC.) 13 September 2018 (2018-09-13)<br>entire document | 1-12 |
| A | US 2016013795 A1 (UNIV. SYDNEY) 14 January 2016 (2016-01-14)<br>entire document | 1-12 |

Form PCT/ISA/210 (second sheet) (January 2015)

**INTERNATIONAL SEARCH REPORT**
Information on patent family members

International application No.

**PCT/CN2021/135511**

| Patent document cited in search report | | | Publication date (day/month/year) | Patent family member(s) | | | Publication date (day/month/year) |
|---|---|---|---|---|---|---|---|
| CN | 111523671 | A | 11 August 2020 | WO | 2020160496 | A1 | 06 August 2020 |
| | | | | EP | 3902768 | A1 | 03 November 2021 |
| | | | | US | 2020250568 | A1 | 06 August 2020 |
| CN | 109406875 | A | 01 March 2019 | CN | 109406875 | B | 15 September 2020 |
| CN | 111722084 | A | 29 September 2020 | CN | 111722084 | B | 20 July 2021 |
| CN | 110488091 | A | 22 November 2019 | CN | 110488091 | B | 08 June 2021 |
| CN | 110612540 | A | 24 December 2019 | KR | 20190134770 | A | 04 December 2019 |
| | | | | WO | 2019005206 | A1 | 03 January 2019 |
| | | | | EP | 3586279 | A1 | 01 January 2020 |
| | | | | US | 2021035005 | A1 | 04 February 2021 |
| | | | | JP | 2020522777 | A | 30 July 2020 |
| | | | | JP | 6852192 | B2 | 31 March 2021 |
| | | | | AU | 2017420803 | A1 | 31 October 2019 |
| | | | | AU | 2017420803 | B2 | 10 December 2020 |
| | | | | CA | 3062793 | A1 | 03 January 2019 |
| | | | | JP | 2021106004 | A | 26 July 2021 |
| CN | 102201811 | A | 28 September 2011 | CN | 102201811 | B | 16 January 2013 |
| US | 2020183768 | A1 | 11 June 2020 | US | 11182230 | B2 | 23 November 2021 |
| US | 2018260732 | A1 | 13 September 2018 | US | 10282675 | B2 | 07 May 2019 |
| | | | | AU | 2018230440 | A1 | 24 October 2019 |
| | | | | EP | 3593298 | A1 | 15 January 2020 |
| | | | | EP | 3593298 | A4 | 20 January 2021 |
| | | | | US | 2021056454 | A1 | 25 February 2021 |
| | | | | US | 11164103 | B2 | 02 November 2021 |
| | | | | WO | 2018165500 | A1 | 13 September 2018 |
| | | | | US | 2020050958 | A1 | 13 February 2020 |
| | | | | US | 10643143 | B2 | 05 May 2020 |
| US | 2016013795 | A1 | 14 January 2016 | AU | 2014271230 | A1 | 28 January 2016 |
| | | | | AU | 2014271230 | B2 | 27 February 2020 |
| | | | | US | 9362929 | B2 | 07 June 2016 |

Form PCT/ISA/210 (patent family annex) (January 2015)

**REFERENCES CITED IN THE DESCRIPTION**

**Patent documents cited in the description**

- CN 202011414104